(19) Europäisches Patentamt
European Patent Office
Office européen des brevets

(11) Veröffentlichungsnummer: **0 006 509**
**B1**

(12) # EUROPÄISCHE PATENTSCHRIFT

(45) Veröffentlichungstag der Patentschrift: **21.04.82**

(51) Int. Cl.³: **H 01 L 21/56**, H 01 L 23/30, H 05 K 3/28

(21) Anmeldenummer: **79101842.7**

(22) Anmeldetag: **11.06.79**

(54) **Verfahren zur Herstellung eines abdichtenden Überzugs auf elektronischen Schaltkreisen und Beschichtungsmaterial.**

(30) Priorität: **26.06.78 US 919356**

(43) Veröffentlichungstag der Anmeldung: **09.01.80 Patentblatt 80/1**

(45) Bekanntmachung des Hinweises auf die Patenterteilung: **21.04.82 Patentblatt 82/16**

(84) Benannte Vertragsstaaten: **DE FR GB**

(56) Entgegenhaltungen:
**DE-A-2 526 052**
**DE-A-2 707 931**
**FR-A-2 335 044**
**US-A-3 515 585**
**US-A-3 931 454**
**EXTENDED ABSTRACTS OF THE JOURNAL OF THE ELECTROCHEMICAL SOCIETY, Vol. 77-2, Oktober 1977, Princeton, USA,**
**R. K. AGNIHOTRI: »Polyimides in lithography«, Seiten 965—966, IBM TECHNICAL DISCLOSURE BULLETIN, Vol. 20, Nr. 6, November 1977, New York, USA,**
**E. SACHER et al.: »Improving bonding strenght of polyimide to silicon wafers«, Seite 2161.**

(73) Patentinhaber: **International Business Machines Corporation, Armonk, N.Y. 10504 (US)**

(72) Erfinder: **Angelo, Raymond W., 3714 Frazier Road, Endwell, New York 13760 (US)**
Erfinder: **Poliak, Richard M., 3223 Lawndale, Endwell, New York 13760 (US)**
Erfinder: **Susko, John R., 15 Longview Avenue, Binghamton, New York 13905 (US)**

(74) Vertreter: **Kreidler, Eva-Maria, Dr. rer. nat., Schönaicher Strasse 220, D-7030 Böblingen (DE)**

**EP 0 006 509 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

BUNDESDRUCKEREI BERLIN

# Verfahren zur Herstellung eines abdichtenden Überzugs auf elektronischen Schaltkreisen und Beschichtungsmaterial

Die Erfindung betrifft ein Verfahren zur Herstellung eines Überzugs aus einem aromatischen Polymer, das sich zu einem Polyimid aushärten läßt, auf elektronischen Schaltkreisen und ein Beschichtungsmaterial zur Durchführung dieses Verfahrens.

Bei der Herstellung integrierter Schaltkreismoduln ist es üblich, die metallischen Leiterzüge und die Verbindungen zwischen der Unterlage und dem Chip mit den integrierten Schaltkreisen mit einer Polymerschicht zu bedecken. Im allgemeinen wird ein flüssiger, abdichtender Überzug über den Vorrichtungen aufgetragen und dann gehärtet, um die kritischen Verbindungen und die Stellen, an denen eine Verbindung zwischen der Unterlage und dem Chip hergestellt wird, gegen Korrosion, Ionenwanderung, atmosphärische Verunreinigungen und Feuchtigkeitseinflüsse zu schützen. Gleichzeitig bewirken die Überzüge auch eine mechanische Verfestigung der Verbindung zwischen Chip und Unterlage und wirken dielektrisch isolierend. Der abdichtende Überzug kann durch Spinnen, Sprühen, Tauchen oder nach einem sonstigen Verfahren aufgetragen werden. Dieses Verfahren ist frei wählbar und hängt von den Anforderungen, die an das Produkt gestellt werden, ab.

Polyimidüberzüge wurden in der Vergangenheit verwendet, um elektronische Komponenten und Schaltkreise abzudichten. Aus der US-Patentschrift 3 515 585 ist beispielsweise ein Verfahren zur Herstellung eines Polyimidüberzugs auf elektronischen Schaltkreisen bekannt, bei dem eine Lösung eines Polyamid-Polyimid-Materials in Dimethylacetamid auf eine Unterlage aufgetragen und durch Einwirken eines weiteren Lösungsmittels zum Gelieren gebracht wird. Das überschüssige Lösungsmittel wird entfernt und das Polymermaterial durch Einwirken von Hitze zu einem Polyimidüberzug ausgehärtet. Bisher war nachteilig, daß die Überzüge die Verbindungstellen, welche unter den Chips lagen, nicht vollständig bedeckten. Es besteht daher ein Bedürfnis für einen gleichmäßigeren Schutzüberzug, der alle Anschlußstellen bedeckt. Außerdem erfordert die Komplexität von Mustern auf Chips, welche Verbindungstellen in der Mitte der Chips wie auch entlang des Randes enthalten, eine weitere Verbesserung hinsichtlich der Benetzbarkeit, so daß die verbesserten Beschichtungsmaterialien zwischen Chip und Unterlage eindringen und eine vollständige Bedeckung der Verbindungsstellen, an denen Chip und Unterlage miteinander verbunden werden und der Lötverbindungen gestatten.

Aufgabe der Erfindung ist, ein Verfahren zur Beschichtung von elektronischen Schaltkreisen anzugeben, mit dem eine vollständige Bedeckung aller Verbindungsstellen erreicht werden kann und ein Beschichtungsmaterial, das eine stark verminderte Oberflächenspannung der Schutzüberzüge in der obersten Schicht gewährleistet.

Die Aufgabe der Erfindung wird gelöst durch ein Verfahren gemäß Patentanspruch 1 und durch die Bereitstellung eines Beschichtungsmaterials zur Durchführung dieses Verfahrens gemäß Patentanspruch 6.

Mit dem erfindungsgemäßen Verfahren gelingt es, die Oberflächenspannung der obersten Schutzschicht erheblich zu erniedrigen. Dadurch wird die Fähigkeit des Überzugs, alle Verbindungen und die Stellen, an denen Chip und Substrat miteinander verbunden werden, benetzen zu können, wesentlich erhöht, was beispielsweise bei der Beschichtung von Moduln, bei denen Chips mit integrierten Schaltkreisen mit dem Substrat verbunden sind gemäß US-Patentschrift 3 429 404 von Vorteil ist. Die Überzugsmaterialien dringen auch unter diejenigen Chips, welche ein Muster mit zu bedeckenden Verbindungen und Verbindungsstellen im Inneren, wie auch am Rande aufweisen.

Die Erfindung wird anhand der nachfolgenden Beschreibung und der Fig. 1 und 2 näher erläutert.

Erfindungsgemäß wird ein Verfahren zur Herstellung eines abdichtenden Überzugs auf elektronischen Schaltkreisen bereitgestellt, bei dem ein Beschichtungsmaterial, das ein aromatisches Polymer, das sich zu einem Polyimid aushärten läßt, ein organisches Lösungsmittel für das Polymer und eine grenzflächenaktive, nicht-ionische Fluorkohlenstoffverbindung enthält, auf die Schaltkreise aufgetragen und zu einem abdichtenden Polyimidüberzug ausgehärtet wird. Es wird auch eine Zusammensetzung angegeben, die ein aromatisches Polymer, das sich zu einem Polyimid aushärten läßt, ein organisches Lösungsmittel für das Polymer und eine grenzflächenaktive, nicht-ionische Fluorkohlenstoffverbindung enthält. Wenn es gewünscht wird, können auch Adhäsionsvermittler wie Silane zu den Zusammensetzungen gegeben werden. Der Ausdruck Polyimid, der hier verwendet wird, umfaßt sowohl Polyimide wie auch Polyamid-Imid-Polymere.

Fig. 1 zeigt einen Aufriß, teilweise im Schnitt, eines Moduls, bei dem Substrat und Chip miteinander verbunden und zwei dieser Einheiten übereinander angeordnet sind.

Fig. 2 ist ein Schnitt einer schematisch dargestellten Lötverbindung zwischen Chip und Modul mit einem abdichtenden Polymerüberzug.

Die vorliegende Erfindung gestattet die Bereitstellung eines Überzugs, welcher eine einheitliche Filmdicke aufweist und frei von Löchern, Hohlräumen und Blasen ist. Die Oberflächenbedingungen, die Schaltkreismetallurgie und die komplexe Konfiguration der Verbindungsstellen erfordern eine verbesserte Benetzung durch den obersten Schutzüberzug, damit eine gute Bedeckung durch den Film gewährleistet wird. Löcher, Hohlräume und Blasen stellen ernsthafte Probleme hinsichtlich der Zuverlässigkeit dar, weil Korrisons- und Auswachsprobleme auftreten, wenn niedrigschmelzende

Lötlegierungen an den Lötverbindungen verwendet werden. Eine unvollständige oder eine fehlende Bedeckung durch die Schutzüberzüge führt zu einer Verschiebung thermischer Spannungen, wodurch die nicht bedeckten Verbindungen und Verbindungsstellen beeinflußt werden und durch die Spannungen ein Reißen auftritt, das zu einem frühzeitigen Ausfall der nicht bedeckten Verbindungen führt.

Wenn Schutzüberzüge auf Moduln, in denen Chips und Unterlage miteinander verbunden sind, aufgetragen werden, ist der Vorteil der verbesserten Benetzbarkeit, welcher eine vollständige Bedeckung gestattet, noch wichtiger. Wie bei planaren Substraten ist auch hier eine vollständige Bedeckung aller Chipverbindungen und Verbindungsstellen erforderlich, um einen ausreichenden Schutz und dadurch eine verlängerte Lebenszeit der Vorrichtung zu gestatten. Außer der Erhöhung der mechanischen Widerstandsfähigkeit der Verbindungsstellen bewirkt ein einheitlicher Schutzüberzug auch eine verbesserte Wärmeübertragungscharaktristik. Die Moduln, die nach dem erfindungsgemäßen Verfahren beschichtet wurden, weisen einen kühleren Bereich zwischen Chip und Unterlage auf, so daß das Chip während des Betriebes kühler bleibt. Fig. 1 zeigt ein Modul 11, bei dem Chip und Unterlage miteinander verbunden sind, und das Anschlußstifte 13 und Chips 15, die durch die Verbindungen 17 auf einer Unterlage 19 befestigt sind und eine Metallkappe 21 aufweist. Fig. 2 ist eine schematische Zeichnung einer einzelnen Lötverbindungsstelle 17 mit Lötmetall 18, welche die Verbindungsstellen 23 auf dem Chip 15 und die Verbindungsstelle 24 auf dem Substrat 19 miteinander verbindet und die Notwendigkeit einer Bedeckung mit der Schutzschicht 25 zeigt. Der typische Abstand von Unterlage zu Chip beträgt etwa 0,102 bis 0,127 mm.

Die Polyimid- und Polyamid-Imidharze, welche zur Durchführung der Erfindung geeignet sind, sind eine Klasse von Polymeren, die aufgrund ihrer ausgezeichneten chemischen Widerstandsfähigkeit und ihrer hohen Temperaturbeständigkeit als Schutzüberzüge mehrlagiger elektronischer Schaltkreise Verwendung finden. Darüber hinaus zeigt diese Gruppe thermoplastischer Polymerer auch gute elektrische und mechanische Eigenschaften.

Die Polymaid-Imid-Polymeren werden aus Anhydriden und Diaminen, beispielsweise aus Pyromellitsäureanhydrid und p,p'-Diaminodiphenylmethan hergestellt.

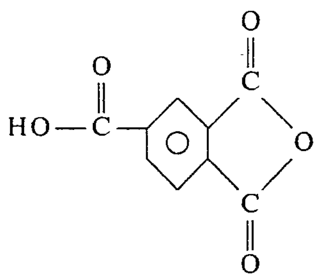

Pyromellitsäureanhydrid

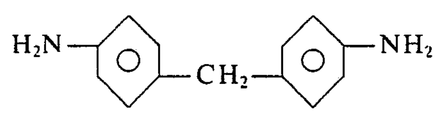

p,p'-Diaminodiphenylmethan

Diese Kombination führt zu einem Polyamidocarbonsäure-Amid-Polymeren, welches beim Härten durch Erhitzen unter Ausbildung von Imidbindungen zyklisiert und zu einem gehärteten Polyamid-Imid führt.

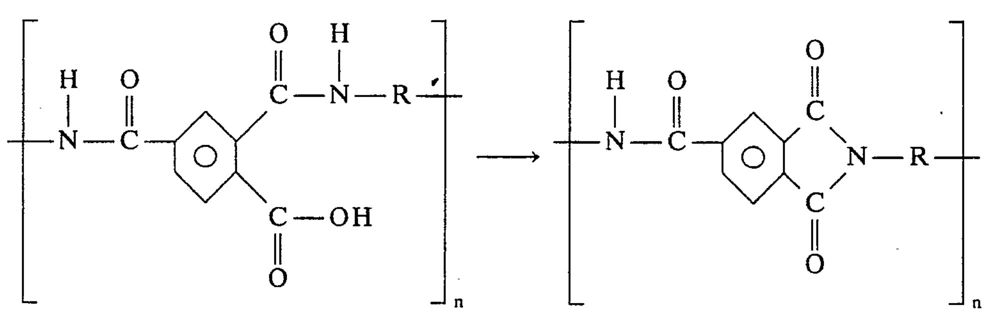

Polyamidocarbonsäureamid Polyamid-Imid

Die Polyimide sind das Reaktionsprodukt aus Dianhydriden und Diaminen, beispielsweise aus Benzophenon-tetracarbonsäureanhydrid und Oxydianilin (4,4'-Diaminodiphenyläther).

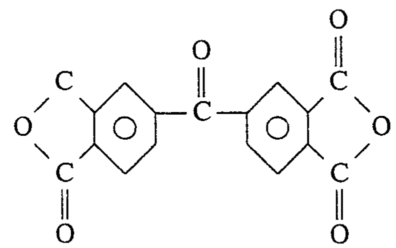 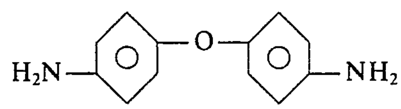

Benzophenontetracarbonsäureanhydrid — Oxydianilin (4,4'-Diaminodiphenyläther)

Nachfolgend ist die Kondensationsreaktion von Pyromellitsäureanhydrid und einem aromatischen Diamin angegeben:

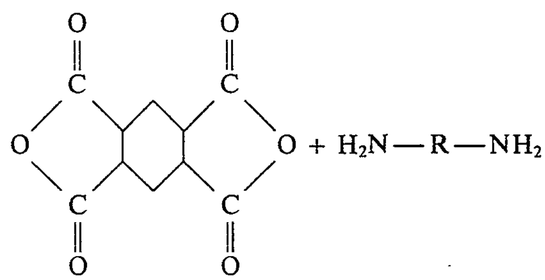

Pyromellitsäureanhydrid — Aromatisches Diamin

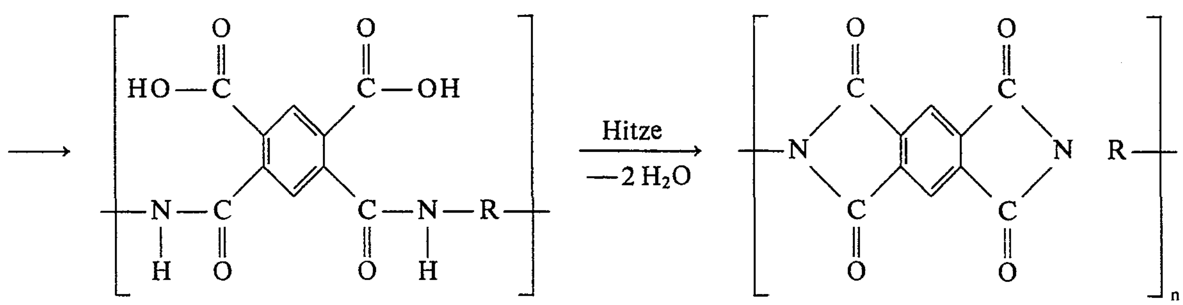


Polyamidocarbonsäure — Gehärtetes aromatisches Polyimid

Andere Materialien wie 4,4'-Diamino-diphenylmethan können zugegeben werden, um die für eine bestimmte Anwendung gewünschten spezifischen Eigenschaften zu erhalten:

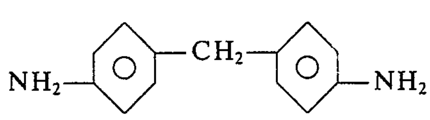

Die Polymeren werden auf die Schaltkreise aus einer Lösung aufgetragen. Bevorzugte Lösungen weisen einen Feststoffgehalt an Polymer von etwa 4 bis 12 Gew.-% in einem organischen Lösungsmittel oder einer Mischung organischer Lösungsmittel gelöst auf.

In Tabelle I sind Beispiele organischer Lösungsmittel, welche als Träger für die Beschichtungszusammensetzungen gemäß der Erfindung geeignet sind, aufgeführt.

Tabelle I

| Lösungsmittel | L. P.*) | F. | Kp. | Fl. P. |
|---|---|---|---|---|
| Dimethylacetamid | 10,8 M | −20 | 166 | 70 |
| Hallcomid M 8–10***) | | −21 | 115–170**) | 118 |
| N-Methyl-pyrrolidon | 11,3 M | −24 | 206 | 85 |
| 1-Formyl-piperidin | 11,5 M | −31 | 222 | |
| Dimethylsulfoxid | 12,0 M | 18 | 189 | 95 |
| Tetramethylharnstoff | | − 1 | 177 | |
| Tetramethylensulfon | 13,4 M | 27 | 285 | |

*) Löslichkeitsparameter aus thermodynamischen Rechnungen, die die Stärke der Wasserstoffbrückenbindung angeben; M bedeutet mäßige Wasserstoffbrückenbindung.
**) bei 3 mm Hg.
***) Warenzeichen der C. P. Hall Co., Mischung von N,N-Dimethylcaprylamid/capramid.

Zusätzlich zu den zuvor angegebenen organischen Lösungsmittel können auch Mischungen oder eine Kombination Lösungsmittel/Verdünnungsmittel angewendet werden. Polyamidocarbonsäure-Zwischenprodukte können für die Herstellung von Polyimiden beispielsweise in den folgenden Kombinationen von Lösungsmittel/Verdünnungsmittel gelöst werden:

1 : 1 Mischung von N-Methylpyrrolidon (NMP)/Aceton
NMP/Cellosolve*) (2-Äthoxyäthanol)
NMP/Xylol
NMP/Toluol
Cellosolve*) (2-Äthoxyäthanol)/Aceton

*) Warenzeichen der Union Carbide Corporation.

Für Polyamid-Imid-bildende Polymere sind Dimethylacetamid, Dimethylformamid, Dimethylsulfoxid und N-Methylpyrrolidon als Lösungsmittel bekannt.
Der Löslichkeitsbereich der Verdünnungskonzentrationen für die Polymeren, angegeben in Gew.-%, umfaßt:

40 bis 50 % aromatische Lösungsmittel (Toluol, Xylol)
40 bis 50 % Ester (Äthylacetat, Methylpropionat)
50 bis 60 % Ketone (Aceton, Methyläthylketon, 80 % Cyclohexanon)
30 bis 40 % hochsiedende Amide, aliphatische Amide mit 1 bis 4 C-Atomen (Acetamid, Propionamid, Butyramid)
40 bis 50 % Cellosolve*) (2-Äthoxyäthanol)

*) Warenzeichen der Union Carbide Corporation.

Die bevorzugten Polyimide und Polyamid-Imide, die erfindungsgemäß verwendet werden, weisen Molekulargewichte von etwa 13.000 bis 60.000 auf. Diese Materialien sind für die vorliegende Erfindung geeignet, weil sie eine hohe Temperaturbeständigkeit in den Überzugszusammensetzungen und gute elektrische Eigenschaften bei Temperaturen >200° C nach der Imidbildung aufweisen.
Zu dieser Mischung wird ein nichtionischer fluorierter Alkylester als grenzflächenaktiver Stoff zugegeben, um die Benetzung, die Verlaufcharakteristik und das Deckvermögen des schützenden Überzugs zu verbessern. Bevorzugte Fluorkohlenwasserstoff-grenzflächenaktive Stoffe sind nichtionische Typen, die die Oberflächenspannung des Polyimids oder der Polyamid-Imidvorläufer auf weniger als 25 Dyn/cm bei 25° C und bei einem Gehalt der Lösung an 0,1 Gew.-% reduzieren.
Nichtionische fluorierte grenzflächenaktive Stoffe sind hervorragend geeignet zur Herstellung einheitlicher Überzüge und um die Einführung von Materialien in den Überzug zu vermeiden, welche eine Korrosion der Metallurgie verursachen können. Es wurde gefunden, daß nichtfluorierte Kohlenwasserstoffe als grenzflächenaktive Stoffe zur Herstellung brauchbarer Überzüge nicht geeignet sind.
In der Fluorkohlenstoffkette der nichtionischen grenzflächenaktiven Stoffe gemäß der Erfindung,

die zyklisch oder nichtzyklisch sein können, müssen die Wasserstoffe an der Kohlenstoffstruktur durch Fluor in dem Maße ersetzt werden, daß die ganze Kette oder der Schwanzteil des flüssigen grenzflächenaktiven Stoffs im wesentlichen ein Fluorkohlenstoff ist. Es ist nicht notwendig, daß Wasserstoff in allen Fällen vollständig ersetzt wird, dieses wird jedoch wegen der leichteren Erhältlichkeit im Handel im allgemeinen der Fall sein. Nichtionische fluorierte Alkylester als grenzflächenaktive Stoffe gemäß der vorliegenden Erfindung enthalten die wiederkehrende Einheit $(CF_2)$ und lassen sich im allgemeinen durch die Formel darstellen:

$$R_f(CH_2)_mOCOR'$$

in der $R_f$ eine Perfluoralkylgruppe mit 3 bis 12 C-Atomen und m eine Zahl von 2 bis 12 und R' Wasserstoff oder Methyl ist.

Die zuvor angegebenen Fluorkohlenstoff-grenzflächenaktiven Stoffe reduzieren die Oberflächenspannung der Amid-Imid-/ oder Imid-Polymerlösungen auf weniger als 25 Dyn/cm, beispielsweise von 39,4 Dyn/cm auf 24,2 Dyn/cm, so daß vollständige und einheitlich abdichtende Überzüge erhalten werden können.

Andere nichtionischen Fluorkohlenstoffe, die als grenzflächenaktive Stoffe im Rahmen der Erfindung verwendet werden können, sind N-Polyoxyäthylen-substituierte Perfluorsulfonamide der allgemeinen Formel:

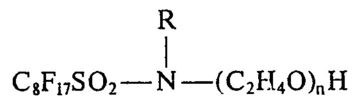

in der R eine Niedrigalkylgruppe mit 1 bis 6 C-Atomen wie Methyl, Äthyl, Propyl, Butyl und dgl. und n eine Zahl von 2 bis 30 ist.

Brauchbar im Rahmen der vorliegenden Erfindung sind auch Fluorkohlenstoffverbindungen aus der Klasse der N-Alkanolperfluoralkansulfonamide mit der allgemeinen Formel:

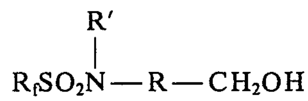

in der $R_f$ eine Perfluoralkylgruppe mit 4 bis 12 C-Atomen, R eine Kohlenwasserstoffkette mit 1 bis 12 $CH_2$-Gruppen und R' Wasserstoff oder eine Alkylgruppe mit 1 bis 6 C-Atomen ist oder die korrespondierenden Ester. Ein Beispiel aus dieser Verbindungsklasse ist N-Propyl-N-äthanol-perfluoroctansulfonamid der allgemeinen Formel

$$C_8F_{17}SO_2N(C_3H_9)CH_2CH_2OH$$

Es können auch Mischungen der zuvor angegebenen grenzflächenaktiven Stoffe verwendet werden.

Ein Silan oder eine Mischung von Silanen kann verwendet werden, um die Adhäsion zwischen dem keramischen Substrat, den metallischen Leiterzügen und dem abdichtenden Überzug zu verbessern. Als Adhäsionspromotoren können Silane mit einer bevorzugten spezifischen Dichte von 0,94 bis 1,06 Gramm/Liter bei 25°C zu den Zusammensetzungen gegeben werden. Brauchbare Silane schließen beispielsweise $\gamma$-Aminopropyltriäthoxysilan; $\beta$-3,4(Epoxycyclohexyl)äthyltrimethoxysilan und $\gamma$-Glycidoxypropyltrimethoxysilan ein. Die Silane werden, wenn es gewünscht wird, in Mengen bis zu etwa 1 Gew.-%, bezogen auf die Gesamtmischung eingesetzt.

Im allgemeinen umfassen die Beschichtungszusammensetzungen gemäß der vorliegenden Erfindung, angegeben in Gew.-%:

| | |
|---|---|
| 2 bis 20 % | Polymer (Polyamidocarbonsäure-Vorläufer von Polyamid-Imid oder Polyimid) |
| 0,001 bis 1 % | nichtionischer Fluorkohlenstoff-grenzflächenaktiver Stoff oder Stoffe |
| 0 bis 1 % | Silan oder eine Mischung von Silanen als Zusatz, wobei der Rest (80 bis 98%) ein organisches Lösungsmittel oder eine Mischung organischer Lösungsmittel und Verdünner ist. |

Bevorzugte Beschichtungszusammensetzungen gemäß der vorliegenden Erfindung enthalten:

| | |
|---|---|
| 4 bis 8 % | Polymer |
| 92 bis 96 % | organisches Lösungsmittel aus der Gruppe von Dimethylacetamid, N-Methylpyrrolidon, 1-Formylpiperidin, Dimethylsulfoxid, Tetramethylharnstoff und Tetramethylensulfon, oder Mischungen derselben |

0,001 bis 0,1% nichtionischer Fluorkohlenstoff-grenzflächenaktiver Stoff,
0 bis 1 % Silanzusatz (wahlweise).

Wie zuvor angegeben, können die Lösungsmittel auch in Verbindung mit Verdünnern verwendet werden. Diese werden verwendet, wenn in bekannter Weise ein bestimmter Löslichkeitsgrad eingestellt werden soll.

Spezifische Zusammensetzungen enthalten:

| | Gew.% | | | |
|---|---|---|---|---|
| | (1) | (2) | (3) | (4) |
| Polyamid-Imide-Vorläufer in Pulverform (AI-10 Polymer von Amoco) | 7,30 | 4,46 | 7,47 | 4,50 |
| Dimethylacetamid | 92,00 | 95,00 | 92,00 | 95,00 |
| Silane: 1 : 1-Verhältnis von $\beta$-(3,4-Epoxycyclohexyl)äthyltrimethoxysilan/2-Aminopropyltriäthoxysilan | 0,65 | 0,44 | 0,46 | 0,45 |
| nichtionischer Fluorkohlenstoff — Alkylester als grenzflächenaktiver Stoff (FC 430, Warenzeichen der 3 M Company) | 0,05 | 0,10 | 0,07 | 0,05 |
| | 100 | 100 | 100 | 100 |

Die Zusammensetzungen 3 und 4 wurden verwendet, um den Effekt des zugesetzten grenzflächenaktiven Stoffes zu messen. Beide zeigten eine von 39,4 Dyn/cm (ohne grenzflächenaktiven Stoff) auf 24,1 Dyn/cm reduzierte Oberflächenspannung.

Wenn man in der Zusammensetzung das Polyamid-Imid bildende Polymer durch ein Polyimid bildendes Polymer ersetzt, wird eine Beschichtungszusammensetzung 5 mit ähnlich erniedrigter Oberflächenspannung erhalten, die erfindungsgemäß zur Verbesserung der benetzenden Eigenschaften eingesetzt werden kann:

| | Gew.-% |
|---|---|
| | (5) |
| Polyimidvorläufer (festes Pulver) | 4,50 |
| N-Methylpyrollidon | 95,00 |
| Silane: 1 : 1-Verhältnis wie in den Zusammensetzungen 1 bis 4 | 0,45 |
| nichtionischer Fluorkohlenstoff-Alkylester als grenzflächenaktiver Stoff (F-430, Warenzeichen der 3M-Company) | 0,05 |

Andere nichtionische Typen fluorierter grenzflächenaktiver Stoffe, wie N-Polyoxyäthylensubstituierte Perfluorsulfonamide und Verbindungen der Klasse der N-Alkanol-perfluoralkansulfonamide können in den zuvor angegebenen Zusammensetzungen verwendet werden.

Die fluorierten grenzflächenaktiven Stoffe gemäß der vorliegenden Erfindung sind nichtionisch im Gegensatz zu kationischen, anionischen oder amphoteren Substanzen. Ionische Materialien sollen in den Schutzüberzügen bewußt vermieden werden.

Es zeigen sich erhebliche Unterschiede beim Vergleich fluorierter grenzflächenaktiver Stoffe mit Stoffen mit wasserstoffhaltigen, grenzflächenaktiven Gruppen. Die Fluorkohlenstoffe bewirken im allgemeinen eine niedrige Kohäsionsoberflächenspannung und weisen ausgezeichnete Löslichkeitsparameter auf, welche nicht erhalten werden, wenn nichtionische Kohlenwasserstoffgrenzflächenaktive Stoffe, wie beispielsweise äthoxylierte Alkylphenole, äthoxylierte aliphatische Alkohole, äthoxylierte Sorbitole oder andere Polyäthylenaddukte verwendet werden.

Kohlenwasserstoff-grenzflächenaktive Stoffe weisen höhere Reibungskoeffizienten auf, und es treten Probleme hinsichtlich der Mischbarkeit (Gelbildung), der korrodierenden Wirkung, der Hygroskopizität, hinsichtlich einer Zersetzung bei niedrigen Temperaturen und einer chemischen Wechselwirkung auf. Es sind auch wesentlich größere Mengen an Kohlenwasserstoffen zur Beeinflussung der Eigenschaften des fertigen Überzugs erforderlich, und ihre Anwendung führte nicht

zu zufriedenstellenden abdichtenden Überzügen, insbesondere, wenn interne Verbindungsstellen zur Verbindung von Chip und Substrat in der Struktur vorhanden sind.

Bei einer praktischen Anwendung wird ein flüssiger Schutzüberzug mit einem Feststoffgehalt von 4 bis 8 Gew.-% Polymer in Mengen von 15 bis 150 mg auf die Vorrichtung mit den Chips aufgetragen, um die Lötverbindungen und Verbindungsstellen zu bedecken. Die Qualität der aufgetragenen Mischung hängt von der Chipgröße und der Anzahl der Chips auf der Unterlage ab. Die genaue Einhaltung einer bestimmten Schichtdicke für den Schutzfilm auf der Lötverbindung bzw. Verbindungsstelle ist nicht kritisch, solange dieselben vollständig bedeckt sind. Der Film sollte vorzugsweise einheitlich sein und eine Schichtdicke unter 0,0254 mm aufweisen (siehe Fig. 2). Eine zu große Menge an der Chip/Substrat-Grenzfläche sollte vermieden werden, um eine zu starke thermische Beanspruchung an der Chipgrenzfläche, welche zu Rißbildungen aufgrund der unterschiedlichen Ausdehnungskoeffizienten des Polymers und des Zinn/Bleilots führt, zu verhindern. Die Überzüge werden gehärtet, indem sie in einem Ofen in dem nachfolgend angegebenen Härtungszyklus gehärtet werden, beispielsweise

a) 60 bis 70 Min. bei 110° C ± 5° C,
b) 60 bis 70 Min. bei 150° C ± 5° C und
c) 180 bis 190 Min. bei 170° C ± 5° C.

Es sei bemerkt, daß die Härtungszeiten und Temperaturen für jede spezielle Mischung an Polymeren und Lösungsmitteln optimiert werden können.

Die Verwendung fluorierter grenzflächenaktiver Stoffe bewirkt, daß die Schutzüberzüge keine Oberflächenverunreinigungen, die durch die Handhabung von Chip und Substrat während des Verfahrens und durch unzureichende Reinigung eingeschleppt werden können, enthalten. Bei verbesserter Benetzung wird eine einheitlichere Bedeckung, besonders unter den schlechtesten Bedingungen erhalten. Die Probleme hinsichtlich der Gleichmäßigkeit der Überzüge, welche auftreten, wenn Polyimidschichten ohne einen Gehalt an grenzflächenaktiven Stoffen verwendet werden, werden durch Maße herabgesetzt, wie es bisher noch nicht erreicht wurde. Es hat sich gezeigt, daß die Anwendung anderer grenzflächenaktiver Stoffe im Hinblick auf diese Eigenschaften nicht so wirksam ist und nebenbei andere Probleme, wie Korrosionserscheinungen und Gelbildung auftreten können.

## Patentansprüche

1. Verfahren zur Herstellung eines abdichtenden Überzugs aus einem aromatischen Polymer, das sich zu einem Polyimid aushärten läßt, auf elektronischen Schaltkreisen, dadurch gekennzeichnet, daß auf die Schaltkreise ein Beschichtungsmaterial mit einem Gehalt an dem aromatischen Polymer, einem organischen Lösungsmittel für dasselbe und einer grenzflächenaktiven, nichtionischen Fluorkohlenstoffverbindung aufgetragen und zu einem abdichtenden Polyimidüberzug ausgehärtet wird.

2. Verfahren nach Anspruch 1, dadurch gekennzeichnet, daß als aromatisches Polymer eine Polyamidocarbonsäure oder ein Polyamidocarbonsäure-amid verwendet wird.

3. Verfahren nach Anspruch 1, dadurch gekennzeichnet, daß als grenzflächenaktive Fluorkohlenstoffverbindung ein nichtionischer fluorierter Alkylester der allgemeinen Formel

$$R_f(CH_2)_mCOOR',$$

in der $R_f$ eine Perfluoralkylgruppe mit 3 bis 12 C-Atomen, m eine Zahl von 2 bis 12 und R' Wasserstoff oder Methyl ist; oder ein N-Polyoxyäthylensubstituiertes Perfluorsulfonamid der allgemeinen Formel

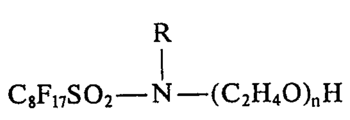

in der R ein Niedrigalkylrest mit 1 bis 6 C-Atomen, wie Methyl, Äthyl, Propyl, Butyl und dergl. und n eine Zahl von 2 bis 30 ist;
oder ein N-Alkanol-perfluoralkansulfonamid der allgemeinen Formel

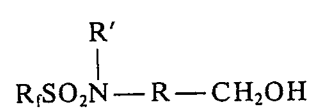

in der $R_f$ eine Perfluoralkylgruppe mit 4 bis 12 C-Atomen, R eine Kohlenwasserstoffkette mit 1 bis 12 $CH_2$-Gruppen und R' Wasserstoff oder eine Alkylgruppe mit 1 bis 6 C-Atomen ist bzw. deren Ester

verwendet werden.

4. Verfahren nach Anspruch 1, dadurch gekennzeichnet, daß ein Beschichtungsmaterial mit einem Gehalt an 2 bis 20, vorzugsweise 4 bis 8 Gew.-% Polymer, 0,001 bis 1 Gew.-% grenzflächenaktivem Stoff und 80 bis 98, vorzugsweise 92 bis 96 Gew.-% Lösungsmittel aufgetragen wird.

5. Verfahren nach einem oder mehreren der Ansprüche 1 bis 4, dadurch gekennzeichnet, daß in dem Beschichtungsmaterial zusätzlich 0 bis 1 Gew.-% Silan-Adhäsionspromotor verwendet wird.

6. Beschichtungsmaterial zur Durchführung des Verfahrens nach den Ansprüchen 1 bis 5, gekennzeichnet durch einen Gehalt an einem aromatischen Polymer, das sich zu einem Polyimid aushärten läßt, einem organischen Lösungsmittel und einer grenzflächenaktiven, nichtionischen Fluorkohlenstoffverbindung.

7. Beschichtungsmaterial nach Anspruch 6, gekennzeichnet durch einen Gehalt an 2 bis 20, vorzugsweise 4 bis 8 Gew.-% Polymer, 0,001 bis 1 Gew.-% grenzflächenaktivem Stoff und 80 bis 98, vorzugsweise 92 bis 96 Gew.-% Lösungsmittel.

8. Beschichtungsmaterial nach den Ansprüchen 6 und 7, dadurch gekennzeichnet, daß es zusätzlich 0 bis 1 Gew.-% Silan-Adhäsionspromotor enthält.

9. Beschichtungsmaterial nach einem oder mehreren der Ansprüche 6 bis 8, dadurch gekennzeichnet, daß es als aromatisches Polymer eine Polyamidocarbonsäure oder ein Polyamidocarbonsäure-Amid enthält.

10. Beschichtungsmaterial nach einem oder mehreren der Ansprüche 6 bis 9, dadurch gekennzeichnet, daß es als grenzflächenaktive Fluorkohlenstoffverbindung einen nichtionischen fluorierten Alkylester der allgemeinen Formel

$$R_f(CH_2)_mCOOR',$$

in der $R_f$ eine Perfluoralkylgruppe mit 3 bis 12 C-Atomen, m eine Zahl von 2 bis 12 und R' Wasserstoff oder Methyl ist; oder ein N-Polyoxyäthylen substituiertes Perfluorsulfonamid der allgemeinen Formel

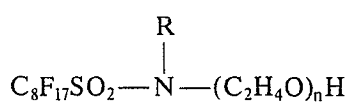

in der R ein Niedrigalkylrest mit 1 bis 6 C-Atomen, wie Methyl, Äthyl, Propyl, Butyl u. dgl. und n eine Zahl von 2 bis 30 ist; oder ein n-Alkanol-perfluoralkansulfonamid der allgemeinen Formel

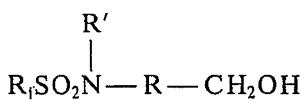

in der $R_f$ eine Perfluoralkylgruppe mit 4 bis 12 C-Atomen, R eine Kohlenwasserstoffkette mit 1 bis 12 $CH_2$-Gruppen und R' Wasserstoff oder eine Alkylgruppe mit 1 bis 6 C-Atomen ist bzw. deren Ester enthält.

**Claims**

1. Method of making a seal coating consisting of an aromatic polymer curable into a polyimide, on electronic circuits, characterized in that onto the circuits a coating material with a content of aromatic polymer, an organic solvent therefor, and a non-ionic fluorocarbon surfactant is applied, and cured into a sealing polyimide coating.

2. Method as claimed in claim 1, characterized in that as an aromatic polymer a polyamic acid or a polyamic acid-amide is used.

3. Method as claimed in claim 1, characterized in that as a fluorocarbon surfactant a non-ionic fluoroinated alkyl ester of the general formula

$$R_f(CH_2)_mCOOR'$$

is used where $R_f$ is a perfluoralkyl group having 3 to 12 C atoms, m an integer from 2 to 12, and R' is either hydrogen or methyl; or an N-polyoxyethylene substituted perfluorosulfonamide of the general formula

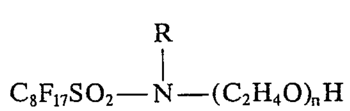

where R is a lower alkyl residue having 1 to 6 C atoms, as methyl, ethyl, propyl, butyl, etc., and n an

integer from 2 to 30; or an N-alkohol perfluoroalkanesulfonamide of the general formula

$$R_fSO_2\overset{\overset{\displaystyle R'}{|}}{N}—R—CH_2OH$$

where $R_f$ is a perfluoroalkyl group having 4 to 12 C atoms, R a hydrocarbon chain having 1 to 12 $CH_2$ groups, and R' is a hydrogen or an alkyl group having 1 to 6 C atoms, and their esters.

4. Method as claimed in claim 1, characterized in that a coating material containing 2 to 20, preferably 4 to 8% by weight of polymer, 0.001 to 1% by weight of a surfactant, and 80 to 98, preferably 92 to 96% by weight of solvent is applied.

5. Method as claimed in one or several of claims 1 to 4, characterized in that in the coating material 0 to 1% by weight of silane adhesion promoter is used additionally.

6. Coating material for carrying out the method as claimed in claims 1 to 5, characterized by a content of an aromatic polymer curable into a polyimide, an organic solvent, and a non-ionic fluorocarbon surfactant.

7. Coating material as claimed in claim 6, characterized by a content of 2 to 20, preferably 4 to 8% by weight of polymer, 0.001 to 1% by weight of a surfactant, and 80 to 98, preferably 92 to 96% by weight of a solvent.

8. Coating material as claimed in claims 6 and 7, characterized in that it additionally contains 0 to 1% by weight of silane adhesion promoter.

9. Coating material as claimed in any one or several of claims 6 to 8, characterized in that as an aromatic polymer it contains a polyamic acid or a polyamic acid-amide.

10. Coating material as claimed in any one or several of claims 6 to 9, characterized in that as a fluorocarbon surfactant it contains a non-ionic fluoroinated alkyl ester of the general formula

$$R_f(CH_2)_mCOOR',$$

where $R_F$ is a perfluoroalkyl group having 3 to 12 C atoms, m an integer from 2 to 12, and R' either hydrogen or methyl; or an N-polyoxyethylene substituted perfluorosulfonamide represented by the general formula

$$C_8F_{17}SO_2—\overset{\overset{\displaystyle R}{|}}{N}—(C_2H_4O)_nH$$

where R is a lower alkyl residue having 1 to 6 C atoms, such as methyl, ethyl, propyl, butyl etc., and n an integer from 2 to 30; or an N-alkanol perfluoroalkanesulfonamide of the general formula

$$R_fSO_2\overset{\overset{\displaystyle R'}{|}}{N}—R—CH_2OH$$

where $R_f$ is a perfluoroalkyl group having 4 to 12 C atoms, R a hydrocarbon chain having 1 to 12 $CH_2$ groups, and R' hydrogen or an alkyl group having 1 to 6 C atoms, and their esters.

**Revendications**

1. Procédé pour réaliser, sur des circuits électroniques, un revêtement étanche composé d'un polymère aromatique pouvant être durci pour obtenir un polyimide, caractérisé en ce qu'on dépose sur les circuits un matériau de revêtement contenant du polymère aromatique, un solvant organique de ce polymère et un composé de fluorocarbone surfactant et non ionique qui est durci pour obtenir un revêtement de polyimide étanche.

2. Procédé selon la revendication 1 caractérisé en ce qu'on utilise comme polymère aromatique un acide polyamide carbonique ou un amide d'acide polyamide carbonique.

3. Procédé selon la revendication 1 caractérisé en ce qu'on utilise comme composé de fluorocarbone surfactant un ester alkyle fluoré non ionique de formule générale

$$R_f(CH_2)_mCOOR'$$

où $R_f$ est un groupe perfluoroalkyle avec 3 à 12 atomes C, m est un entier de 2 à 12 et R' est de l'hydrogène ou du méthyl; ou qu'on utilise un perfluorosulfanomide substitué par du N-polyoxyéthylène de la formule générale

$$C_8F_{17}SO_2-\overset{R}{\overset{|}{N}}-(C_2H_4O)_nH$$

où R est un résidu d'alkyle faible avec 1 à 6 atomes C, tel que le méthyl, éthyl, propyl, butyl, etc., et n un entier de 2 à 30; ou qu'on utilise un N-alkanol-perfluoro-alkanesulfonamide de la formule générale

$$R_fSO_2\overset{R'}{\overset{|}{N}}-R-CH_2OH$$

où $R_f$ est un groupe perfluoroalkyle avec 4 à 12 atomes C, R est une chaîne d'hydrocarbure avec 1 à 12 groupes $CH_2$, et R' est un hydrogène ou un groupe d'alkyle ayant de 1 à 6 atomes C ou les esters de celui-ci.

4. Procédé selon la revendication 1, caractérisé en ce qu'on dépose un matériau de revêtement contenant de 2 à 20, de préférence de 4 à 8% en poids de polymère, de 0,001 à 1% en poids de matériau surfactant, et de 80 à 98, de préférence de 92 à 96% en poids de solvant.

5. Procédé selon l'une quelconque ou plusieurs des revendications 1 à 4, caractérisé en ce qu'on utilise dans le matériau de revêtement en outre de 0 à 1% en poids d'agent favorisant l'adhésion de silane.

6. Matériau de revêtement pour exécuter le procédé selon les revendications 1 à 5, caractérisé en ce qu'il contient un polymère aromatique pouvant être durci pour obtenir un polyimide, un solvant organique et un composé de fluorocarbone surfactant non ionique.

7. Matériau de revêtement selon la revendication 6, caractérisé en ce qu'il contient de 2 à 20%, de préférence de 4 à 8% en poids de polymère, de 0,001 à 1% en poids de materiau surfactant, et de 80 à 98%, de préférence de 92 à 96%, en poids de solvant.

8. Matériau de revêtement selon les revendications 6 et 7, caractérisé en ce qu'il contient en plus de 0 à 1% en poids d'agent favorisant l'adhésion de silane.

9. Matériau de revêtement selon l'une quelconque ou plusieurs des revendications 6 à 8, caractérisé en ce qu'il contient un polymère aromatique, un acide carbonique polyamide ou un amide d'acide carbonique polyamide.

10. Matériau de revêtement selon l'une quelconque ou plusieurs des revendications 6 à 9, caractérisé en ce qu'il contient comme composé de fluorocarbone surfactant un ester alkyle fluoré non ionique de la formule générale

$$R_f(CH_2)_mCOOR',$$

où $R_f$ est un groupe perfluoroalkyle ayant de 3 à 12 atomes C, m est un entier de 2 à 12, et R' est de l'hydrogène ou du méthyl; ou qu'il contient un perfluorosulfonamide substitué par un N-polyoxyéthylène de la formule générale

$$C_8F_{17}SO_2-\overset{R}{\overset{|}{N}}-(C_2H_4O)_nH$$

où R est un résidu d'alkyle faible ayant de 1 à 6 atomes C, tel que le méthyl, l'éthyl, le propyl, le butyl, etc., et n est un entier de 2 à 30; ou qu'il contient un N-alkanol-perfluoro-alkanesulfonamide de la formule générale

$$R_fSO_2\overset{R'}{\overset{|}{N}}-R-CH_2OH$$

où $R_f$ est un groupe perfluoroalkyle ayant de 4 à 12 atomes C, R est une chaîne d'hydrocarbure ayant de 1 à 12 groupes $CH_2$, et R' est de l'hydrogène ou un groupe d'alkyle ayant de 1 à 6 atomes C ou les esters de ceux-ci.

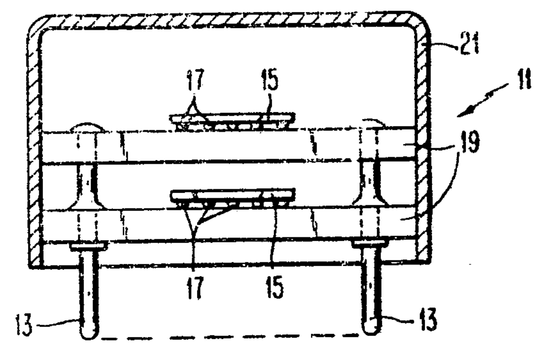


FIG. 1

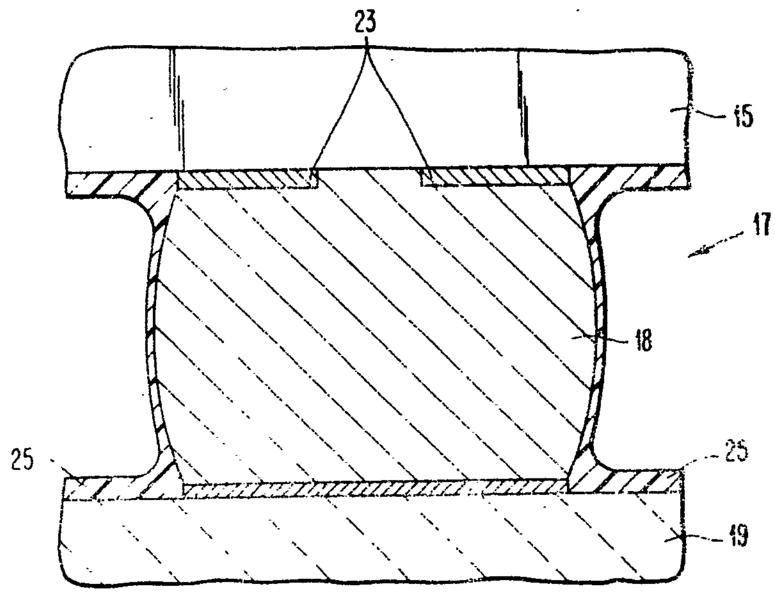


FIG. 2